(19) Europäisches Patentamt
European Patent Office
Office européen des brevets

(11) **EP 4 617 409 A1**

(12) **EUROPÄISCHE PATENTANMELDUNG**

(43) Veröffentlichungstag:
**17.09.2025   Patentblatt 2025/38**

(21) Anmeldenummer: **24162681.1**

(22) Anmeldetag: **11.03.2024**

(51) Internationale Patentklassifikation (IPC):
**C30B 23/02** *(2006.01)*      **C30B 29/36** *(2006.01)*

(52) Gemeinsame Patentklassifikation (CPC):
**C30B 29/36; C30B 23/025**

(84) Benannte Vertragsstaaten:
**AL AT BE BG CH CY CZ DE DK EE ES FI FR GB GR HR HU IE IS IT LI LT LU LV MC ME MK MT NL NO PL PT RO RS SE SI SK SM TR**
Benannte Erstreckungsstaaten:
**BA**
Benannte Validierungsstaaten:
**GE KH MA MD TN**

(71) Anmelder: **SiCrystal GmbH**
**90411 Nürnberg (DE)**

(72) Erfinder:
• **Schuh, Philipp**
**90411 Nürnberg (DE)**

• **Müller, Ralf**
**90411 Nürnberg (DE)**
• **Stockmeier, Matthias**
**90411 Nürnberg (DE)**
• **Vogel, Michael**
**90411 Nürnberg (DE)**
• **Ecker, Bernhard**
**90411 Nürnberg (DE)**
• **Klietz, Wenzel**
**90411 Nürnberg (DE)**

(74) Vertreter: **Rau, Schneck & Hübner**
**Patentanwälte Rechtsanwälte PartGmbB**
**Königstraße 2**
**90402 Nürnberg (DE)**

(54) **HERSTELLUNGSVERFAHREN FÜR EINEN SIC-VOLUMENEINKRISTALL**

(57)     Das Verfahren ist zur Herstellung eines SiC-Volumeneinkristalls mittels Sublimationszüchtung bestimmt. An einem scheibenförmigen einkristallinen SiC-Keimkristall (2) eine Spannungsmessung zur Erfassung anfänglicher innerer mechanischer Keim-Spannungen durchgeführt wird, wobei der SiC-Keimkristall (2) eine Scheiben-Vorderseite (4) mit einer zum Aufwachsen des zu züchtenden SiC-Volumeneinkristalls bestimmten Wachstumsoberfläche (3), eine Scheiben-Rückseite (5) und eine in einer axialen Richtung verlaufende Kristallmittenlängsachse (6) hat, wobei eine radiale Richtung senkrecht zur axialen Richtung orientiert ist. Weiterhin wird anhand der Spannungsmessung eine Klassifikation des SiC-Keimkristalls (2) vorgenommen, wobei der SiC-Keimkristall (2), in eine erste Klasse eingestuft wird, wenn die erfassten anfänglichen Keim-Spannungen einen ersten Spannungsgrenzwert unterschreiten, in eine zweite Klasse eingestuft wird, wenn die erfassten anfänglichen Keim-Spannungen zwischen dem ersten Spannungsgrenzwert und einem zweiten Spannungsgrenzwert liegen, oder in eine dritte Klasse eingestuft wird, wenn die erfassten anfänglichen Keim-Spannungen den zweiten Spannungsgrenzwert überschreiten. Die eigentliche Sublimationszüchtung, während der der SiC-Volumeneinkristall auf dem SiC-Keimkristall (2) aufwächst, wird nur dann mit dem SiC-Keimkristall (2) durchgeführt, wenn er in die erste oder in die zweite Klasse eingestuft worden ist, wobei bei Einstufung in die zweite Klasse mindestens eine spannungsreduzierende Maßnahme ergriffen wird.

Fig. 1

EP 4 617 409 A1

**Beschreibung**

Die Erfindung betrifft ein Verfahren zur Herstellung mindestens eines SiC-Volumeneinkristalls mittels Sublimationszüchtung.

Das Halbleitermaterial Siliziumcarbid (SiC) wird aufgrund seiner herausragenden physikalischen, chemischen, elektrischen und optischen Eigenschaften unter anderem auch als Ausgangsmaterial für leistungselektronische Halbleiterbauelemente, für Hochfrequenzbauelemente und für spezielle lichtgebende Halbleiterbauelemente eingesetzt. Für diese Bauelemente werden SiC-Substrate (= SiC-Wafer) mit möglichst großem Substratdurchmesser und möglichst hoher Qualität benötigt. Basis hierfür sind hochwertige SiC-Volumeneinkristalle.

Solche SiC-Volumeneinkristalle werden in der Regel mittels physikalischer Gasphasenabscheidung (PVT), z.B. mittels eines in der US 8,865,324 B2 beschriebenen Sublimationsverfahrens, hergestellt. Dabei wird eine einkristalline SiC-Scheibe als SiC-Keimkristall zusammen mit geeignetem Quellmaterial in einen Züchtungstiegel eingebracht. Unter kontrollierten Temperatur-, Druck- und Gasbedingungen wird das Quellmaterial sublimiert. Die gasförmigen Spezies (= SiC, $Si_2C$, $SiC_2$) werden aufgrund eines axialen Temperaturgefälles (= Temperaturgradient) zu dem SiC-Keimkristall transportiert und scheiden sich dort aus der SiC-Wachstumsgasphase auf dem SiC-Keimkristall ab, wodurch der SiC-Volumeneinkristall aufwächst.

Aus diesen SiC-Volumeneinkristallen werden die scheibenförmigen einkristallinen SiC-Substrate beispielsweise mittels einer Fadensäge herausgeschnitten, die dann nach einer insbesondere mehrstufigen Polierbehandlung ihrer Oberflächen im Rahmen der Bauelementefertigung mit mindestens einer insbesondere auch aus SiC bestehenden Epitaxieschicht versehen werden. In der Regel werden Defekte aus dem SiC-Substrat in die aufgebrachte Epitaxieschicht vererbt und führen damit zu einer Verschlechterung der Bauelementeeigenschaften. Die Qualität der Bauelemente hängt also wesentlich von der des gezüchteten SiC-Volumeneinkristalls und der daraus gewonnenen SiC-Substrate ab.

Für die Herstellung der epitaktischen Schichten der Bauelemente ist die Geometrie des verwendeten SiC-Substrats von großer Bedeutung. So erreicht man in einem Epitaxie-Reaktor eine gute thermische Ankopplung, welche für homogenes und qualitativ hochwertiges epitaktisches Schichtwachstum sehr wichtig ist, im Wesentlichen nur bei SiC-Substraten, die keine nennenswerte Verbiegung aufweisen. Dagegen führen SiC-Substrate mit schlechten Geometrieeigenschaften, also insbesondere mit zu großer Verbiegung (engl.: bow) und/oder Wölbung (engl.: warp), zwangsläufig zu geringerer Qualität bzw. geringerer Ausbeute des Epitaxie-Prozesses.

Ein weiterer Aspekt, der die Qualität der SiC-Substrate beeinträchtigen kann, sind Spannungen im Material. Im gezüchteten SiC-Volumeneinkristall vorhandenen Spannungen können nämlich zur Bildung von Kristalldefekten (z.B. vor allem von Versetzungen), zu Brüchen bei der weiteren Verarbeitung oder zu Verformungen (siehe vorstehend) der aus einem solchen SiC-Volumeneinkristall gefertigten SiC-Substrate führen. Dadurch wird die wirtschaftliche Herstellbarkeit der SiC-Substrate massiv beeinträchtigt. Außerdem lassen sich SiC-Substrate mit solchen spannungsbedingten Verformungen nur noch eingeschränkt weiterverwenden.

In der EP 3 048 641 A1 wird die Messung dieser Spannungen in SiC-Substraten beschrieben, um die Verbiegung, die die SiC-Substrate bei der weiteren Verarbeitung zeigen werden, abzuschätzen. Hierfür geeignete Messverfahren beruhen auf der Erfassung und Auswertung von Raman-Streuung bzw. Raman-Verschiebung am SiC-Kristallgitter oder von Röntgenstrahlbeugung am SiC-Kristallgitter.

Die unerwünschten Spannungen können bei der SiC-Kristallzüchtung während des Aufwachsvorgangs aufgrund der für das Kristallwachstum notwendigen Temperaturgradienten entstehen. Diese thermischen Effekte ergeben sich dadurch, dass einerseits eine Triebkraft für den Materialtransport benötigt wird (= Temperaturunterschied vom SiC-Quellmaterial zum SiC-Keimkristall), und andererseits die Wachstumsgrenzfläche (= Wachstumsoberfläche) des wachsenden SiC-Volumeneinkristalls eine gewisse konvexe Krümmung aufweisen muss, um die Ausbreitung von Defekten aus dem radialen Randbereich in Richtung Kristallzentrum zu verhindern. Die Spannungen im SiC-Volumeneinkristall können aber auch durch Kräfte verursacht werden, die sich zwischen einer Tiegelwand und dem gezüchteten SiC-Volumeneinkristall, beispielsweise während des Abkühlens nach Abschluss des eigentlichen Züchtungsvorgangs aufgrund eines unterschiedlichen Abkühlverhaltens des Züchtungstiegels und des SiC-Volumeneinkristalls, ausbilden. Ursächlich sind hier also Wandeffekte. Die für Spannungen im Material verantwortlichen thermischen Effekte und Wandeffekte werden durch Prozessparameter während der SiC-Züchtung ausgelöst oder bestimmt. Durch eine geeignete Konstruktion der Züchtungsvorrichtung und/oder eine geeignete Prozessführung kann den thermischen Effekten und den Wandeffekten als Spannungsursachen zumindest in gewissem Umfang entgegengewirkt werden.

So wird in der CN 218860954 U beschrieben, dass die Temperatur innerhalb des SiC-Keimkristalls vereinheitlicht wird. Temperaturunterschiede und somit aufgrund der thermischen Effekte resultierende innere Spannungen in dem SiC-Keimkristall sollen so vermieden werden. Hierzu wird auf der Rückseite der SiC-Keimkristalls eine mehrteilige thermische Isolation angeordnet, die ein verschiebbares Anpassungselement enthält. Durch dessen Verschiebung lässt sich ein auf der Rückseite des SiC-Keimkristalls ebenfalls vorhandener Hohlraum in seiner Abmessung an die jeweiligen (thermischen) Verhältnisse anpassen. Diese Konstruktion ist allerdings aufwändig und damit auch kostenträchtig.

In der CN 116334748 A wird beschrieben, dass zur Vermeidung von durch Wandeffekte verursachten Spannungen ein zweilagiger Einsatz mit porösem Graphit in der inneren Lage und mit hartem Graphit in der äußeren Lage zwischen die Innenwand des Züchtungstiegels und den SiC-Keimkristall sowie den darauf aufwachsenden SiC-Volumeneinkristall eingebracht wird.

Darüber hinaus wird der SiC-Keimkristall bei den meisten SiC-Züchtungsprozessen in geeigneter Weise mit dem zur Züchtung verwendeten konstruktiven Aufbau fest verbunden. Eine derartige feste Klebeverbindung des SiC-Keimkristalls mit dem dann auch als Keimhalter dienenden Tiegeldeckel wird beispielsweise in der US 2011/0229719 A1 beschrieben. Daneben ist auch eine andere Ausführungsform offenbart, bei der der SiC-Keimkristall mittels einer seitlichen mechanischen Halterung an dem Tiegeldeckel befestigt wird. Der SiC-Keimkristall liegt hierbei nur lose an der seitlichen Halterung und dem Tiegeldeckel an. In der CN 110306239 A wird die Verwendung eines Tiegeldeckels aus polykristallinem SiC beschrieben. An diesem wiederum auch als Keimhalter dienenden Tiegeldeckel ist der SiC-Keimkristall mittels einer festen Klebeverbindung angebracht.

Die Aufgabe der Erfindung besteht darin, ein Verfahren der eingangs bezeichneten Art anzugeben, das verglichen mit bekannten Verfahren die Herstellung eines noch spannungsärmeren SiC-Volumeneinkristalls ermöglicht.

Zur Lösung dieser Aufgabe wird ein Verfahren entsprechend den Merkmalen des Anspruchs 1 angegeben. Bei dem erfindungsgemäßen Verfahren wird an einem scheibenförmigen einkristallinen SiC-Keimkristall eine Spannungsmessung zur Erfassung anfänglicher innerer mechanischer Keim-Spannungen durchgeführt, wobei der SiC-Keimkristall eine Scheiben-Vorderseite mit einer zum Aufwachsen des zu züchtenden SiC-Volumeneinkristalls bestimmten Wachstumsoberfläche, eine insbesondere der Scheiben-Vorderseite gegenüberliegende Scheiben-Rückseite und eine in einer axialen Richtung verlaufende Kristallmittenlängsachse hat, und wobei eine radiale Richtung senkrecht zur axialen Richtung orientiert ist. Weiterhin wird anhand der Spannungsmessung eine Klassifikation des SiC-Keimkristalls vorgenommen, wobei der SiC-Keimkristall in eine erste Klasse eingestuft wird, wenn die erfassten anfänglichen Keim-Spannungen einen ersten Spannungsgrenzwert unterschreiten, in eine zweite Klasse eingestuft wird, wenn die erfassten anfänglichen Keim-Spannungen zwischen dem ersten Spannungsgrenzwert und einem zweiten Spannungsgrenzwert liegen, oder in eine dritte Klasse eingestuft wird, wenn die erfassten anfänglichen Keim-Spannungen den zweiten Spannungsgrenzwert überschreiten. Weiterhin wird die eigentliche Sublimationszüchtung, während der der SiC-Volumeneinkristall auf dem SiC-Keimkristall aufwächst, nur dann mit dem SiC-Keimkristall durchgeführt, wenn er in die erste oder in die zweite Klasse eingestuft worden ist, wobei bei Einstufung in die zweite Klasse mindestens eine spannungsreduzierende Maßnahme ergriffen wird.

Der Begriff "Sublimationszüchtung" ist hier allgemein zu verstehen. Insbesondere umfasst er auch Schritte zur Vor- und/oder Nachbereitung des eigentlichen Züchtungsvorgangs, der hier auch als eigentliche Sublimationszüchtung bezeichnet wird.

Die Spannungsmessung zur Erfassung anfänglicher innerer mechanischer Keim-Spannungen kann an dem scheibenförmigen einkristallinen SiC-Keimkristall insbesondere in seinem unverbauten bzw. unmontierten Zustand oder insbesondere auch in einem fest montierten Zustand als Bestandteil einer Keimeinheit erfolgen. Diese Keimeinheit kann außerdem insbesondere einen Keimhalter und ein Verbindungsmedium, wie z.B. eine Klebeschicht, zwischen dem SiC-Keimkristall und dem Keimhalter aufweisen. Die Keimeinheit kann auch als Keimsystem bezeichnet werden. Bei einer Messung an einem unmontierten SiC-Keimkristall sind die gemessenen anfänglichen Keim-Spannungen die Spannungen, die bei der Herstellung des SiC-Keimkristalls in seinem Kristallgefüge entstanden sind. Bei einer Messung an einem in einer Keimeinheit fest montierten SiC-Keimkristall setzen sich die gemessenen anfänglichen Keim-Spannungen aus zwei Spannungsanteilen zusammen, nämlich zum einen wiederum aus den Spannungen, die bei der Herstellung des SiC-Keimkristalls in seinem Kristallgefüge entstanden sind, als erstem Spannungsanteil, aber zum anderen auch aus einem zweiten Spannungsanteil, der sich aufgrund der unterschiedlichen Ausdehnungskoeffizienten des SiC-Keimkristalls und der übrigen Komponenten der Keimeinheit, z.B. des Keimhalters und des Verbindungsmediums, ergibt.

Bei der bei Einstufung in die zweite Klasse zu ergreifenden mindestens einen spannungsreduzierenden Maßnahme handelt es sich insbesondere um eine zusätzliche Maßnahme, die andernfalls, beispielsweise bei Einstufung in die erste Klasse, normalerweise nicht ergriffen würde.

Der scheibenförmige SiC-Keimkristall hat insbesondere eine im Wesentlichen zylindrische Geometrie. Eine Umfangsrandfläche des SiC-Keimkristalls hat insbesondere im Wesentlichen die Form einer zylindrischen Mantelfläche.

Während der Züchtung wächst der SiC-Volumeneinkristall in axialer Richtung auf dem SiC-Keimkristall auf und hat die gleiche Kristallmittenlängsachse wie der SiC-Keimkristall bzw. die Keimeinheit. Mit "axial" ist hier eine Richtung parallel zur oder längs der insbesondere zentralen Kristallmittenlängsachse, mit "radial" eine dazu senkrechte Richtung und mit "tangential" eine um die Kristallmittenlängsachse umlaufende Umfangsrichtung zu verstehen.

Es wurde erkannt, dass unerwünschte Spannungen innerhalb des SiC-Volumeneinkristalls auch durch anfängliche Keim-Spannungen hervorgerufen werden können, die bereits vor Züchtungsbeginn innerhalb des SiC-Keimkristalls oder innerhalb der mit ihm gebildeten Keimeinheit (= Keimsystem) vorhanden sind und aus dem SiC-Keimkristall bzw. aus der Keimeinheit auf den darauf aufwachsenden SiC-Volumeneinkristall übertragen werden. Ursächlich sind hier also Keimeffekte.

Spannungen im aufwachsenden SiC-Volumeneinkristall, die auf solchen Keimeffekten beruhen, sind schwieriger als andere Spannungen zu beeinflussen. Außerdem haben anfängliche Keim-Spannungen aus dem SiC-Keimkristall bzw. der Keimeinheit während des Züchtungsvorgangs einen viel größeren Einfluss auf den aufwachsenden SiC-Volumeneinkristall als dies von anderen Züchtungsverfahren, die zur Herstellung anderer technologisch bedeutsamer Kristalle eingesetzt werden, bekannt ist. Bei der SiC-Züchtung wird üblicherweise ein SiC-Keimkristall eingesetzt, der einen vergleichbaren Durchmesser wie der darauf aufwachsende SiC-Volumeneinkristall hat. Wenn überhaupt, kann während der SiC-Züchtung nur eine geringe Durchmesservergrößerung erreicht werden, was die SiC-Züchtung von Dünnhals-Kristallzüchtungsverfahren, wie sie z.B. bei der Züchtung von reinen Silizium (Si)-Kristallen eingesetzt werden, unterscheidet.

Um dem Einfluss der anfänglichen Keim-Spannungen aus dem SiC-Keimkristall bzw. der Keimeinheit auf den Spannungshaushalt im aufwachsenden SiC-Volumeneinkristall entgegenwirken zu können, müssen diese anfänglichen Keim-Spannungen bekannt sein, weshalb sie bei dem erfindungsgemäßen Verfahren gemessen werden.

Die Erkenntnisse aus dieser insbesondere individuell für jeden SiC-Keimkristall durchgeführten Spannungsmessung werden dann zunächst für die Entscheidung verwendet, ob sich der untersuchte SiC-Keimkristall überhaupt für die Züchtung eines SiC-Volumeneinkristalls eignet (= erste und zweite Klasse), und falls ja, ob hierzu eine spannungsreduzierende Maßnahme zu ergreifen ist (= zweite Klasse) oder nicht (= erste Klasse). Falls der untersuchte SiC-Keimkristall aufgrund seines Spannungshaushalts in die zweite Klasse fällt und dementsprechend eine spannungsreduzierende Maßnahme erforderlich ist, wird der Züchtungsprozess an die im SiC-Keimkristall vorliegenden Spannungs-Verhältnisse angepasst, um so während der Züchtung auf die anfänglichen Keim-Spannungen zu reagieren. Dadurch wird den anfänglichen Keim-Spannungen entgegengewirkt und es kann ein sehr spannungsarmer SiC-Volumeneinkristall gezüchtet werden. Auf spannungsarmen in die erste Klasse fallenden SiC-Keimkristallen können solche sehr spannungsarmen SiC-Volumeneinkristalle auch ohne spannungsreduzierende Maßnahme aufwachsen.

Mit dem erfindungsgemäßen Verfahren ist es erstmals möglich, die anfänglichen Keim-Spannungen in jedem SiC-Keimkristall individuell zu bestimmen und bei festgestelltem Bedarf mit geeigneten maßgeschneiderten spannungsreduzierenden Maßnahmen bei der SiC-Kristallzüchtung darauf zu reagieren. Dadurch können die Volumeneinkristall-Spannungen in den wachsenden SiC-Volumeneinkristallen signifikant reduziert werden, was auch zu einer deutlichen Verbesserung der Qualität bei den SiC-Substraten führt, die aus den so hergestellten SiC-Volumeneinkristallen gewonnen werden. Die Substratqualität verbessert sich unmittelbar durch die massiv verringerte Spannungsweitergabe aus dem SiC-Keimkristall.

Vorteilhafte Ausgestaltungen des erfindungsgemäßen Verfahrens ergeben sich unter anderem aus den Merkmalen der von Anspruch 1 abhängigen Ansprüche.

Günstig ist eine Ausgestaltung, bei der anhand der Spannungsmessung eine insbesondere vollständige und/oder insbesondere relative Spannungsverteilung der anfänglichen Keim-Spannungen in dem SiC-Keimkristall ermittelt wird. Dadurch liegen sehr genaue Erkenntnisse zu den Spanungsverhältnissen in dem SiC-Keimkristall vor, so dass die Entscheidungen für die weitere Verwendung des untersuchten SiC-Keimkristalls besonders fundiert getroffen werden kann.

Gemäß einer weiteren günstigen Ausgestaltung wird als erster Spannungsgrenzwert eine zwischen einem auf der Kristallmittenlängsachse angeordneten Zentrum des SiC-Keimkristalls und einem radialen Randbereich des SiC-Keimkristalls gemessene Spannungsdifferenz, die im Bereich zwischen 5 MPa und 15 MPa, insbesondere im Bereich zwischen 7,5 MPa und 12,5 MPa, und vorzugsweise bei 10 MPa liegt, verwendet. Gemäß einer weiteren günstigen Ausgestaltung wird als zweiter Spannungsgrenzwert eine zwischen einem auf der Kristallmittenlängsachse angeordneten Zentrum des SiC-Keimkristalls und einem radialen Randbereich des SiC-Keimkristalls gemessene Spannungsdifferenz, die im Bereich zwischen 400 MPa und 600 MPa, insbesondere im Bereich zwischen 450 MPa und 550 MPa, und vorzugsweise bei 500 MPa liegt, verwendet. Insbesondere wird zur Ermittlung der Spannungsdifferenz eine erste Differenzspannungsmessung im Zentrum des SiC-Keimkristalls sowie eine zweite Differenzspannungsmessung in dem radialen Randbereich durchgeführt. Insbesondere wird die zweite Differenzspannungsmessung in dem radialen Randbereich an einem Randmesspunkt durchgeführt, der in radialer Richtung um einen Randabstand entfernt von einer den SiC-Keimkristall seitlich begrenzenden Seitenwand bzw. von einem seitlichen Rand des SiC-Keimkristalls, wobei der Randabstand insbesondere einen Wert zwischen 0,5 mm und 6 mm, vorzugsweise einen Wert zwischen 1 mm und 5 mm und bevorzugt einen Wert von 1 mm oder von 3 mm oder von 5 mm hat.

Gemäß einer weiteren günstigen Ausgestaltung wird die Spannungsmessung an dem SiC-Keimkristall mittels einer Röntgenbeugungsmessung, Neutronenbeugungsmessung, einer Messung der Raman-Verschiebung oder einer Messung der Photoelastizität durchgeführt. Insbesondere ist auch eine beliebige Kombination dieser Messmethoden möglich. Anhand dieser Messmethoden lassen sich die anfänglichen Keim-Spannungen in dem Materialgefüge des SiC-Keimkristalls zerstörungsfrei, kontaminationsfrei, ortsaufgelöst und sehr genau bestimmen. Vergleichbare Ergebnisse sind mit anderen Methoden, wie z.B. Computer-Simulationen der eingesetzten Züchtungsvorrichtungen, nicht möglich. Diese anderen Methoden können allenfalls unzureichende grobe Abschätzungen der Spannungsverhältnisse im SiC-Keimkristall liefern.

Gemäß einer weiteren günstigen Ausgestaltung besteht die mindestens eine spannungsreduzierende Maßnahme darin, die Scheiben-Rückseite des SiC-Keimkristalls in Kontakt mit Spannungsreduktionselementen zu bringen, wobei die Spannungsreduktionselemente unterschiedliche Wärmeleitfähigkeiten haben. Insbesondere kontaktieren die Spannungsreduktionselemente den SiC-Keimkristall unmittelbar oder direkt, was vorzugsweise bei einem an der Scheiben-Rückseite frei zugänglichen SiC-Keimkristall erfolgt. Alternativ kann die Scheiben-Rückseite des SiC-Keimkristalls aber auch nur in mittelbaren Kontakt zu den Spannungsreduktionselementen gebracht werden, was vorzugsweise dann erfolgt, wenn an der Scheiben-Rückseite des SiC-Keimkristalls bereits eine andere Komponente direkt anliegt, wie dies z.B. bei einer Einbindung oder Montage des SiC-Keimkristalls in eine Keimeinheit der Fall sein kann.

Gemäß einer weiteren günstigen Ausgestaltung besteht die mindestens eine spannungsreduzierende Maßnahme darin, dass zur Sublimationszüchtung eine Vorrichtung verwendet wird, die in einem Bereich, der sich axial an die Scheiben-Rückseite des in die Vorrichtung eingebrachten SiC-Keimkristalls anschließt, mindestens einen Quer-Hohlraum aufweist. Vorzugsweise wird der Quer-Hohlraum unmittelbar benachbart zur der Scheiben-Rückseite des SiC-Keimkristalls angeordnet. Dann ist die Einflussnahme auf die Keim-Spannungen besonders gut und effizient. Bevorzugt wird der Quer-Hohlraum in einer axialen Stirnwand eines zur Sublimationszüchtung als Bestandteil der Vorrichtung verwendeten Züchtungstiegels angeordnet. Dadurch resultiert ein sehr kompakter, aber dennoch wirksamer Aufbau, dessen äußere und innere Konturen sowie Abmessungen sich praktisch nicht von denen einer SiC-Züchtungsvorrichtung ohne spannungsreduzierende Maßnahme unterscheidet.

Gemäß einer weiteren günstigen Ausgestaltung besteht die mindestens eine spannungsreduzierende Maßnahme darin, dass zur Sublimationszüchtung eine Vorrichtung mit einem Züchtungstiegel verwendet wird, wobei eine benachbart zu dem in die Vorrichtung eingebrachten SiC-Keimkristall angeordnete axiale Stirnwand des Züchtungstiegels mindestens eine insbesondere außenseitige Ausnehmung aufweist. Auch dadurch ergibt sich ein sehr kompakter und wirksamer Aufbau.

Gemäß einer weiteren günstigen Ausgestaltung besteht die mindestens eine spannungsreduzierende Maßnahme darin, dass zur Sublimationszüchtung eine Vorrichtung mit einem Züchtungstiegel verwendet wird, wobei eine den SiC-Keimkristall und einen Kristallwachstumsbereich, insbesondere tangential oder konzentrisch zur Kristallmittenlängsachse, umgebende Seitenwand des Züchtungstiegels mindestens einen Längs-Hohlraum aufweist. Wiederum resultiert ein sehr kompakter, wirksamer Aufbau, dessen äußere und innere Konturen sowie Abmessungen sich praktisch nicht von denen einer SiC-Züchtungsvorrichtung ohne spannungsreduzierende Maßnahme unterscheidet.

Gemäß einer weiteren günstigen Ausgestaltung besteht die mindestens eine spannungsreduzierende Maßnahme darin, dass die Scheiben-Rückseite des SiC-Keimkristalls mit einer insbesondere ein- oder mehrlagigen Rückseiten-Schichtkomponente beschichtet wird. Die Rückseiten-Schichtkomponente kann insbesondere nur eine einzige Schicht haben oder sich bevorzugt auch aus mehreren Einzelschichten oder Einzellagen zusammensetzen, die radial nebeneinander und/oder axial übereinander angeordnet sein können. Die Rückseiten-Schichtkomponente bedeckt den SiC-Keimkristall insbesondere vollständig. Vorzugsweise werden für die Rückseiten-Schichtkomponente mindestens zwei voneinander verschiedene Schichtmaterialien mit insbesondere unterschiedlichen Wärmeleitfähigkeiten vorgesehen. Dadurch lässt sich eine besonders gute spannungsreduzierende Wirkung und eine sehr gute Kompensation der anfänglich im SiC-Keimkristall enthaltenen Keim-Spannungen erreichen.

Gemäß einer weiteren günstigen Ausgestaltung wird eine beliebige Kombination der vorstehend beschriebenen günstigen spannungsreduzierenden Maßnahmen verwendet.

Gemäß einer weiteren günstigen Ausgestaltung wird insbesondere nach Abschluss der eigentlichen Sublimationszüchtung eine insbesondere vollständige Spannungsverteilung der inneren mechanischen Volumeneinkristall-Spannungen in dem hergestellten SiC-Volumeneinkristall ermittelt. Die Ermittlung einer vollständigen Spannungsverteilung wird insbesondere auch als Spannungs-Mapping bezeichnet. Vorzugsweise wird anhand der ermittelten Spannungsverteilung die weitere Verwendung des SiC-Volumeneinkristalls festgelegt. Bevorzugt wird die Spannungsverteilung der Volumeneinkristall-Spannungen mittels einer Röntgenbeugungsmessung, Neutronenbeugungsmessung, einer Messung der Raman-Verschiebung oder einer Messung der Photoelastizität ermittelt. Insbesondere ist auch eine beliebige Kombination dieser Messmethoden möglich.

Weitere Merkmale, Vorteile und Einzelheiten der Erfindung ergeben sich aus der nachfolgenden Beschreibung von Ausführungsbeispielen anhand der Zeichnung. Es zeigt:

Fig. 1    ein Ausführungsbeispiel einer Messanordnung zur Erfassung von Keim-Spannungen eines scheibenförmigen SiC-Keimkristalls in schematischer Ansicht,

Fig. 2 eine Draufsicht auf eine Scheiben-Vorderseite des messtechnisch untersuchten SiC-Keimkristalls gemäß Fig. 1,

Fig. 3 eine für den untersuchten SiC-Keimkristall gemäß Fig. 1 und 2 ermittelte Spannungsverteilung sowie eine Draufsicht auf Spannungsreduktionselemente zur Kontaktierung der Scheibenrückseite des SiC-Keimkristalls gemäß Fig. 1 und 2, und

Fig. 4 bis 9 Ausführungsbeispiele von Züchtungsvorrichtungen zur Züchtung eines SiC-Volumeneinkristalls auf einem messtechnisch gemäß Fig. 1 untersuchten SiC-Keimkristall.

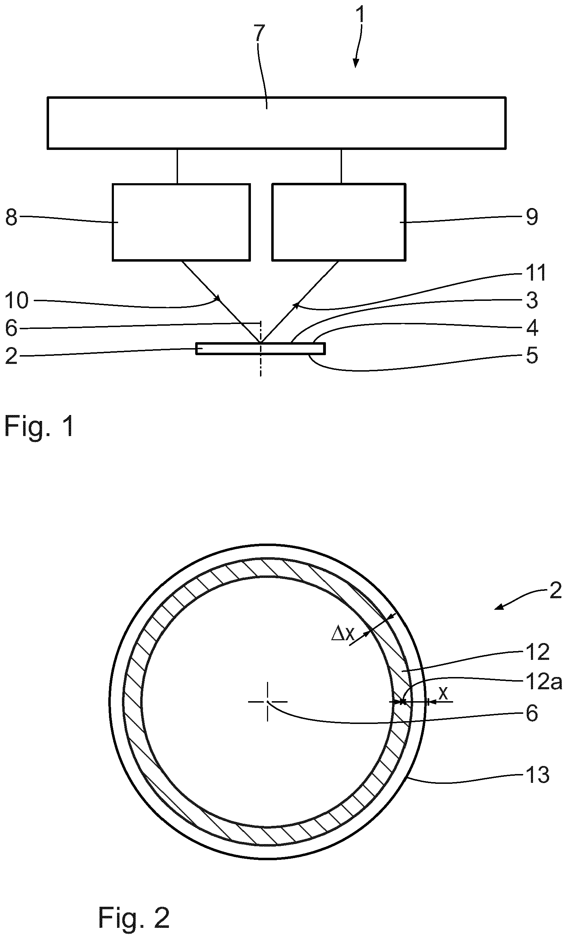

Einander entsprechende Teile sind in den Fig. 1 bis 9 mit denselben Bezugszeichen versehen. Auch Einzelheiten der im Folgenden näher erläuterten Ausführungsbeispiele können für sich genommen eine Erfindung darstellen oder Teil eines Erfindungsgegenstands sein.

In Fig. 1 ist in nur sehr schematischer Darstellung ein Ausführungsbeispiel einer Messanordnung 1 zur Untersuchung eines einkristallinen scheibenförmigen SiC-Keimkristalls 2 gezeigt.

Der zur Züchtung eines SiC-Volumeneinkristalls bestimmte SiC-Keimkristall 2 ist in Fig. 1 in einer Seitenansicht und in Fig. 2 in einer Draufsicht dargestellt. Der SiC-Keimkristall 2 hat eine Wachstumsoberfläche 3 zum Aufwachsen des zu züchtenden SiC-Volumeneinkristalls, die an einer Scheiben-Vorderseite 4 des SiC-Keimkristalls 2 angeordnet ist. Der SiC-Keimkristall 2 hat außerdem eine der Scheiben-Vorderseite 4 gegenüberliegende Scheiben-Rückseite 5.

Weiterhin weist der SiC-Keimkristall 2 eine zentrale Kristallmittenlängsachse 6 auf. Sie fällt mit der mittigen Symmetrieachse der insbesondere zylinderförmigen Geometrie des SiC-Keimkristalls 2 zusammen. Eine Richtung längs der Kristallmittenlängsachse 6 oder parallel zu derselben wird hier als axial bezeichnet. Eine Richtung senkrecht zu der Kristallmittenlängsachse 6 wird als radial bezeichnet. Tangential ist eine um die Kristallmittenlängsachse 6 umlaufende Umfangsrichtung.

Die in Fig. 1 gezeigte Messanordnung 1 ist zur Erfassung von Keim-Spannungen bestimmt, die anfänglich, das heißt bereits vor Beginn des eigentlichen SiC-Züchtungsvorgangs, im Kristallgefüge des SiC-Keimkristalls 2 vorhanden sind. Bei dem in Fig. 1 gezeigten Ausführungsbeispiel ist der untersuchte SiC-Keimkristall 2 unmontiert. Bei einem alternativen Ausführungsbeispiel kann der SiC-Keimkristall 2 während der messtechnischen Untersuchung in montiertem Zustand vorliegen, beispielsweise als Bestandteil einer Keimeinheit. Er ist dann mit anderen Komponenten der betreffenden Keimeinheit insbesondere fest verbunden. Die bei einem solchen montierten SiC-Keimkristall 2 erfassten Keim-Spannungen setzen sich aus zwei Spannungsanteilen zusammen. Der erste Spannungsanteil betrifft die bereits angesprochenen Spannungen, die im Kristallgefüge des SiC-Keimkristalls 2 aufgrund dessen Herstellung vorhanden sind. Der zweite Spannungsanteil wird durch die unterschiedlichen thermischen Ausdehnungskoeffizienten der verschiedenen montierten Einzelkomponenten der betreffenden Keimeinheit verursacht.

Die Messanordnung 1 weist eine Steuer-/Auswerteeinheit 7, eine Sendeeinheit 8 und eine Empfangseinheit 9 auf. Von der Sendeeinheit 8 wird nach einer entsprechenden Ansteuerung durch die Steuer-/Auswerteeinheit 7 ein Abfragesignal 10 auf den SiC-Keimkristall 2 gerichtet, wo eine Wechselwirkung mit dessen spannungsbehaftetem Kristallgefüge stattfindet. Durch diese Wechselwirkung wird das Abfragesignal 10 beeinflusst, so dass es eine Information über die im SiC-Keimkristall 2 vorhandenen Keim-Spannungen enthält. Anschließend gelangt es als Antwortsignal 11 zu der Empfangseinheit 9, wo es detektiert wird. Die Auswertung erfolgt dann durch die Steuer-/Auswerteeinheit 7, die sowohl an die Sendeeinheit 8 als auch an die Empfangseinheit 9 angeschlossen ist.

Die Messanordnung 1 ist weiterhin dazu ausgelegt, eine vollständige Spannungsverteilung der Keim-Spannungen in dem SiC-Keimkristall 2 zu ermitteln. Dazu wird das Abfragesignal 10 auf verschiedene Stellen der Wachstumsoberfläche 3 an der Scheiben-Vorderseite 4 des SiC-Keimkristalls 2 gerichtet. Grundsätzlich das Abfragesignal 10 bei einer alternativen Untersuchungsmethode auch an der Scheiben-Rückseite 5 auf den SiC-Keimkristall 2 gerichtet werden. Nach Abschluss der die Wachstumsoberfläche 3 abtastenden Untersuchung liegt in der Steuer-/Auswerteeinheit 7 ein vollständiges Bild der Spannungsverteilung in dem SiC-Keimkristall 2 vor. Anhand dessen wird entschieden, wie der SiC-Keimkristall 2 weiterverwendet werden soll. Hierzu erfolgt eine Klassifizierung anhand von zwei Spannungsgrenzwerten $\sigma_{G1}$ und $\sigma_{G2}$. Der SiC-Keimkristall 2 wird in eine erste Klasse eingestuft, wenn die erfassten Keim-Spannungen den ersten Spannungsgrenzwert $\sigma_{G1}$ unterschreiten. Eine Einstufung in die zweite Klasse erfolgt, wenn die Keim-Spannungen zwischen dem ersten Spannungsgrenzwert $\sigma_{G1}$ und dem zweiten Spannungsgrenzwert $\sigma_{G2}$ liegen. Der dritten Klasse wird der SiC-Keimkristall 2 zugeordnet, wenn die erfassten Keim-Spannungen den zweiten Spannungsgrenzwert $\sigma_{G2}$ überschreiten.

Dabei sind die beiden Spannungsgrenzwerte $\sigma_{G1}$ und $\sigma_{G2}$ jeweils als Differenz aus zwei erfassten Spannungswerten gebildet. Der erste Spannungswert wird im Zentrum auf der Kristallmittenlängsachse 6 des SiC-Keimkristalls 2 ermittelt, der zweite Spannungswert in einem (in Fig. 2 schraffiert gekennzeichneten) radialen Randbereich 12. Der radiale Randbereich 12 grenzt nicht unmittelbar an einen seitlichen Umfangsrand 13 des SiC-Keimkristalls 2 an, sondern beginnt erst ein Stück weit radial entfernt von diesem seitlichen Umfangsrand 13. Der zweite Spannungswert wird an einem innerhalb des radialen Randbereichs 12 liegenden Randmesspunkt 12a erfasst. Dessen radialer Randabstand x von dem seitlichen Umfangsrand 13 liegt insbesondere in einem Bereich zwischen 1 mm und 5 mm. Die radiale Ausdehnung $\Delta$x des radialen Randbereichs 12 beträgt damit 4 mm. Bei dem gezeigten Ausführungsbeispiel wird der zweite für die Spannungsdifferenz benötigte Spannungswert in einem Randabstand x von etwa 3 mm erfasst. Die so definierten Spannungsgrenzwerte für die Klassifizierung des SiC-Keimkristalls liegen bei dem Ausführungsbeispiel bei 10 MPa für den ersten Spannungsgrenzwert $\sigma_{G1}$ und bei 500 MPa für den zweiten Spannungsgrenzwert $\sigma_{G2}$. Für den zur Klassifizierung durchzuführenden Vergleich der erfassten Keim-Spannungen mit diesen beiden Spannungsgrenzwerten $\sigma_{G1}$ und $\sigma_{G2}$ wird dementsprechend eine Differenz der im Zentrum des untersuchten SiC-Keimkristalls 2 am Ort der Kristallmittenlängsachse 6 ermittelten Keim-Spannung und einer in dem radialen Randbereich 12, bei dem gezeigten Ausführungsbeispiel mit einem Randabstand x von 3 mm entfernt vom seitlichen Umfangsrand 13 am Randmesspunkt 12a, erfassten zweiten Keim-Spannung gebildet und mit den beiden Spannungsgrenzwerten $\sigma_{G1}$ und $\sigma_{G2}$ verglichen.

Die weitere Verwendung des so untersuchten SiC-Keimkristalls 2 richtet sich nach der Klassifizierung. Bei einer Einstufung in die erste Klasse hat der untersuchte SiC-Keimkristall 2 nur sehr niedrige anfänglichen Keim-Spannungen. Er kann ohne zusätzliche Maßnahmen zur Züchtung eines spannungsarmen SiC-Volumeneinkristalls verwendet werden. Bei einer Einstufung in die zweite Klasse weist der SiC-Keimkristall 2 stärkere anfängliche Keim-Spannungen auf, die aber dennoch noch eine Verwendung des SiC-Keimkristalls 2 für die Züchtung eines SiC-Volumeneinkristalls erlauben, wenn zusätzliche spannungsreduzierende Maßnahmen ergriffen werden, die während der SiC-Kristallzüchtung den anfänglichen Keim-Spannungen entgegenwirken und insofern das Aufwachsen eines spannungsarmen SiC-Volumeneinkristalls ermöglichen. Bei der Einstufung in die dritte Klasse hat der SiC-Keimkristall 2 zu hohe anfängliche Keim-Spannungen, so dass er nicht zur Züchtung eines SiC-Volumeneinkristalls eingesetzt werden kann. Er wird stattdessen aussortiert.

Das bei der Messanordnung 1 zugrundeliegende Messprinzip kann variieren. Die Spannungsmessung an dem SiC-Keimkristall 2 kann insbesondere mittels einer Messung der Raman-Verschiebung, einer Messung der Photoelastizität, einer Röntgenbeugungsmessung und/oder einer Neutronenbeugungsmessung erfolgen.

Im Folgenden wird die Spannungsmessung mittels Messung der Raman-Verschiebung erläutert.

Aufgrund der starken kovalenten Si-C Bindungen sind die durch Spannungen verursachten Effekte auf die Raman-Verschiebung sehr klein, weshalb eine absolute Messung der Spannungen schwierig ist. Deshalb wird eine relative Messung verwendet, bei der über ein die gesamte Wachstumsoberfläche 3 des untersuchten SiC-Keimkristalls 2 abdeckendes Punktraster die Raman-Verschiebungswerte bezogen auf einen Referenzpunkt (in der Regel das Zentrum Wachstumsoberfläche 3) bestimmt werden. Die Spannung kann aus dem folgenden Zusammenhang abgeleitet werden:

$$\Delta\omega = \Psi \cdot \sigma$$

wobei $\Psi$ den Spannungs-Dehnungs-Frequenzverschiebungsfaktor des Materials, $\Delta\omega$ das Frequenzverschiebungsinkrement und $\sigma$ die Spannung bezeichnet.

Im Folgenden wird die Spannungsmessung mittels Messung der Photoelastizität erläutert.

Durch den Einfluss von Spannungen auf die Anordnung der Atome in der Kristallstruktur des Materials werden auch die optischen Eigenschaften beeinflusst. Ein Lichtstrahl, der durch das Material dringt, wird in zwei Strahlen mit unterschiedlichen Ausbreitungsgeschwindigkeiten zerlegt; dadurch entsteht bei polarisiertem Licht eine Phasenverzögerung, wodurch auf die Spannungen im Material geschlossen werden kann. Maßgeblich ist die folgende Gleichung:

$$\Delta = \frac{2\pi t}{\lambda} C(\sigma_1 - \sigma_2)$$

wobei $\Delta$ die Phasenverzögerung, C den spannungsoptischen Koeffizienten, t die Dicke der Probe, $\lambda$ die Vakuumlichtwellenlänge, $\sigma_1$ und $\sigma_2$ die erste bzw. zweite Hauptspannung bezeichnet.

Im Folgenden wird die Spannungsmessung mittels Röntgenbeugungsmessung und Neutronenbeugungsmessung erläutert.

Der Einfluss der Spannungen auf die Anordnung der Atome in der Kristallstruktur beeinflusst auch die Ergebnisse von Beugungsexperimenten und kann auf diese Weise bestimmt werden. Durch die Spannungen werden die Netzebenenabstände der Kristallstruktur verändert, was sich durch Röntgen- oder Neutronenbeugungsexperimente messen lässt. Darüber kann auf die Spannungen und die Spannungsrichtung im Material geschlossen werden. Maßgeblich sind hier die folgenden Gleichungen:

$$\varepsilon_{hkl} = (d_{hkl} - d_{hkl,0}) \cdot d_{hkl,0}$$

$$\sigma_{hkl} = E \cdot \varepsilon_{hkl}$$

wobei $\varepsilon_{hkl}$ die Verbiegung der betrachteten Beugungs-

ebene, $d_{hkl}$ der reale Netzebenenabstand, $d_{hkl,0}$ der ideale, unverspannte Netzebenenabstand, E das Elastizitätsmodul und $\sigma_{hkl}$ die Spannung bezeichnet.

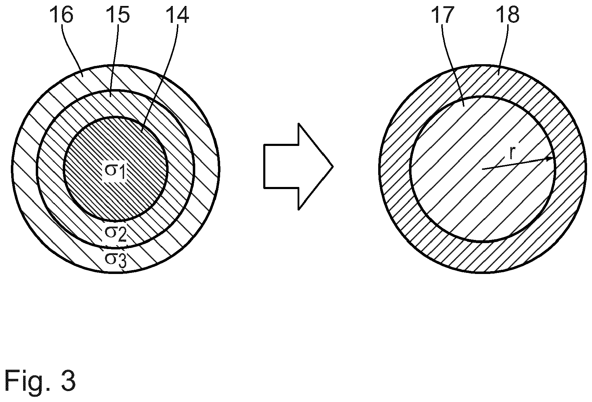

Nach Ermittlung einer vollständigen Spannungsverteilung (= Spannungs-Mapping) innerhalb des untersuchten SiC-Keimkristalls 2 zum Beispiel mit eine der oben beschriebenen Methoden, kann der scheibenförmige SiC-Keimkristall 2 in geeignete Zonen mit unterschiedlichen Spannungs-Wertebereichen eingeteilt werden, die aufgrund der bei der SiC-Kristallzüchtung herrschenden Verhältnisse im Allgemeinen radialsymmetrisch sind (siehe linke Abbildung in Fig. 3).

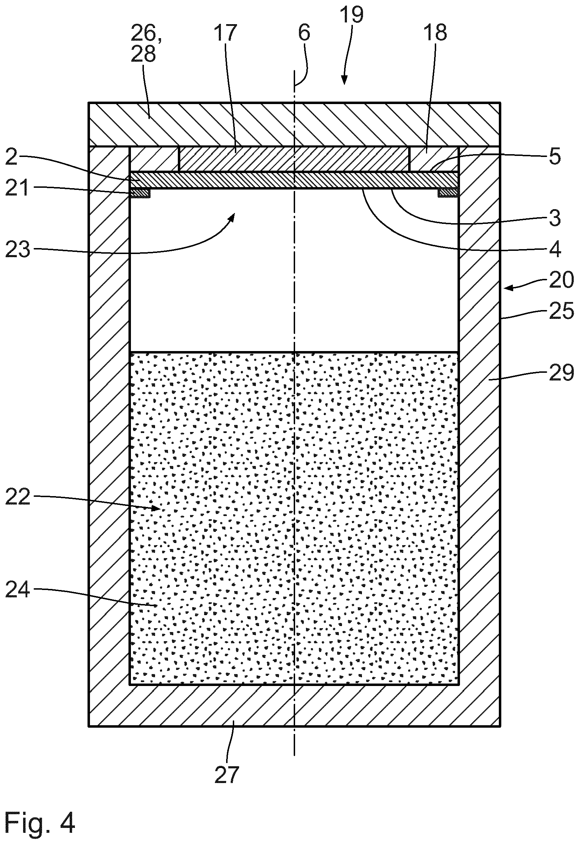

Wie bereits erwähnt, wird ein in die zweite Klasse eingestufter SiC-Keimkristall 2 zur Züchtung eines SiC-Volumeneinkristalls verwendet, wobei allerdings zusätzliche Maßnahmen (siehe Fig. 3 rechte Abbildung sowie Fig. 4 bis 9) ergriffen werden, um während des eigentlichen SiC-Züchtungsvorgangs die Spannungen zu reduzieren.

In Fig. 3 ist in der linken Abbildung ein aus der ermittelten Spannungsverteilung abgeleitetes Spannungszonen-Diagramm eines untersuchten SiC-Keimkristalls 2, der in die zweite Klasse eingestuft worden ist, gezeigt. Gemäß dem Spannungszonen-Diagramm weist dieser SiC-Keimkristall 2 einen inneren, wenig verspannten Zentralbereich 14 mit anfänglichen Keim-Spannungen $\sigma 1$, einen Übergangsbereich 15 mit etwas höheren anfänglichen Keim-Spannungen $\sigma 2$ und einem stark verspannten Randbereich 16 mit relativ hohen anfänglichen Keim-Spannungen $\sigma 3$ auf. Die drei Bereiche 14, 15 und 16 sind jeweils radialsymmetrisch und konzentrisch zueinander angeordnet. Die Keim-Spannungen $\sigma 1$, $\sigma 2$, $\sigma 3$ können auch als Spannungsdifferenzwerte vorliegen, bei denen jeweils der im Zentrum ermittelte Wert als Referenzwert für die Differenzbildung herangezogen wird.

Die in der linken Abbildung von Fig. 3 schematisch gezeigte Spannungsverteilung eines untersuchten SiC-Keimkristalls 2 mit stärker verspanntem Randbereich 16 ist hauptsächlich auf die während der Herstellung des betreffenden SiC-Keimkristalls 2 eingesetzten konvex gekrümmten Isothermen zurückzuführen. Um den anfänglichen Keim-Spannungen $\sigma 1$, $\sigma 2$, $\sigma 3$ entgegenzuwirken, wird während der SiC-Sublimationszüchtung eines auf diesem SiC-Keimkristall 2 aufwachsenden SiC-Volumeneinkristalls die Wärmeabfuhr aus dem SiC-Keimkristall 2 im stark verspannten Randbereich 16 gegenüber dem wenig verspannten Zentralbereich 14 erhöht. Dadurch wird die Krümmung der Isothermen während der SiC-Sublimationszüchtung des SiC-Volumeneinkristalls lokal verringert. Dies erfolgt beispielsweise über die Verwendung von in der rechten Abbildung von Fig. 3 gezeigten Spannungsreduktionselementen 17 und 18, die eine unterschiedliche Wärmeleitfähigkeit haben und die an der Scheiben-Rückseite 5 mit dem SiC-Keimkristall 2 in direktem Kontakt gebracht werden. Die beiden Spannungsreduktionselemente 17 und 18 sind jeweils radialsymmetrisch ausgebildet und konzentrisch zueinander angeordnet. Der Radius r, der die Grenze zwischen dem zentralen Spannungsreduktionselement 17 und dem es tangential umgebenden äußeren ringförmigen Spannungsreduktionselement 18 bestimmt, wird aufgrund der ermittelten kompletten Verteilung der anfänglichen Keim-Spannungen innerhalb des SiC-Keimkristalls 2 gewählt. Auf diese Weise werden die Züchtungsbedingungen während der SiC-Sublimationszüchtung des SiC-Volumeneinkristalls individuell an die im hierfür verwendeten SiC-Keimkristall 2 herrschenden Spannungsverhältnisse angepasst. Bei dem gezeigten Ausführungsbeispiel hat das innere Spannungsreduktionselement 17 eine niedrigere Wärmeleitfähigkeit als das äußere Spannungsreduktionselement 18. Aufgrund der zusätzlich vorgesehenen spannungsreduzierenden Maßnahmen enthält der so gezüchtete SiC-Volumeneinkristall nur sehr niedrige innere Spannungen. Aus ihm können insofern sehr hochwertige SiC-Substrate und daraus mit hoher Ausbeute ebenfalls hochwertige SiC-Bauelemente hergestellt werden.

In Fig. 4 ist ein Ausführungsbeispiel einer Züchtungsvorrichtung 19 zur Herstellung eines (nicht mit dargestellten) SiC-Volumeneinkristalls mittels Sublimationszüchtung und unter Verwendung des messtechnisch gemäß Fig. 1 untersuchten SiC-Keimkristalls 2 gezeigt.

Bei der Züchtungsvorrichtung 19 kommen die Spannungsreduktionselemente 17 und 18 gemäß Fig. 3 zum Einsatz. Sie sind lose an der Scheiben-Rückseite 5 des SiC-Keimkristalls 2 platziert, welcher in einem Züchtungstiegel 20 mittels eines Keimhalters 21 gehalten wird.

Der Züchtungstiegel 20 umfasst einen SiC-Vorratsbereich 22 sowie einen Kristallwachstumsbereich 23 umfasst. In dem SiC-Vorratsbereich 22 befindet sich beispielsweise pulverförmiges SiC-Quellmaterial 24.

Der Züchtungstiegel 20 hat ein Tiegelgefäß 25 und einen Tiegeldeckel 26. Der Züchtungstiegel 20 hat eine erste axiale Stirnwand 27, die benachbart zu dem SiC-Vorratsbereich 22 angeordnet ist, und eine dem gegenüberliegende zweite axiale Stirnwand 28, die durch den Tiegeldeckel 26 gebildet ist. Außerdem hat der Züchtungstiegel 20 eine tangential umlaufende Seitenwand 29, welche wie die erste axiale Stirnwand 27 Bestandteil des Tiegelgefäßes 25 ist. Der SiC-Keimkristall 2 ist mittels des Keimhalters 21 so im Züchtungstiegel 20 positioniert, dass die Scheiben-Vorderseite 4 des SiC-Keimkristalls 2 mit der Wachstumsoberfläche 3 im Kristallwachstumsbereich 23 angeordnet ist. Bei dem gezeigten Ausführungsbeispiel liegt die Scheiben-Vorderseite 4 des SiC-Keimkristalls 2 im Bereich des Umfangsrands lose auf dem ringförmigen Keimhalter 21 auf.

Der Züchtungstiegel 20 besteht aus einem elektrisch und thermisch leitfähigen Graphit-Tiegelmaterial. Um ihn herum ist eine in Fig. 4 nicht mit dargestellte thermische Isolation angeordnet. Zur Beheizung des Züchtungstiegels 20 ist außerdem eine ebenfalls nicht mit dargestellte, insbesondere induktive Heizeinrichtung, in Form einer Heizspule vorhanden. Der Züchtungstiegel 20 wird mittels dieser Heizeinrichtung auf die für die Züchtung erforderlichen hohen Temperaturen von über 2100° C erhitzt.

Die SiC-Wachstumsgasphase im Kristallwachstumsbereich 23 wird durch das SiC-Quellmaterial 24 gespeist. Die SiC-Wachstumsgasphase enthält zumindest Gasbestandteile in Form von SiC, $Si_2C$ und $SiC_2$ (= SiC-Gasspezies). Der Materialtransport vom SiC-Quellmaterial 24 zu der Wachstumsoberfläche 3 erfolgt längs eines axialen Temperaturgradienten, der mittels der Heizeinrichtung eingestellt wird und parallel zu der Kristallmittenlängsachse 6 verläuft. An der Wachstumsoberfläche 3 herrscht eine relativ hohe Wachstumstemperatur von mindestens 2100° C, insbesondere sogar von mindestens 2200° C oder 2300° C. Dort werden Gasbestandteile der SiC-Wachstumsgasphase abgeschieden, was zum Aufwachsen des SiC-Volumeneinkristalls führt. Die Temperatur nimmt innerhalb des Züchtungstiegels 20 von dem SiC-Quellmaterial 24 in axialer Richtung bis zu dem Tiegeldeckel 26 ab, wodurch der angesprochene axiale Temperaturgradient gebildet wird.

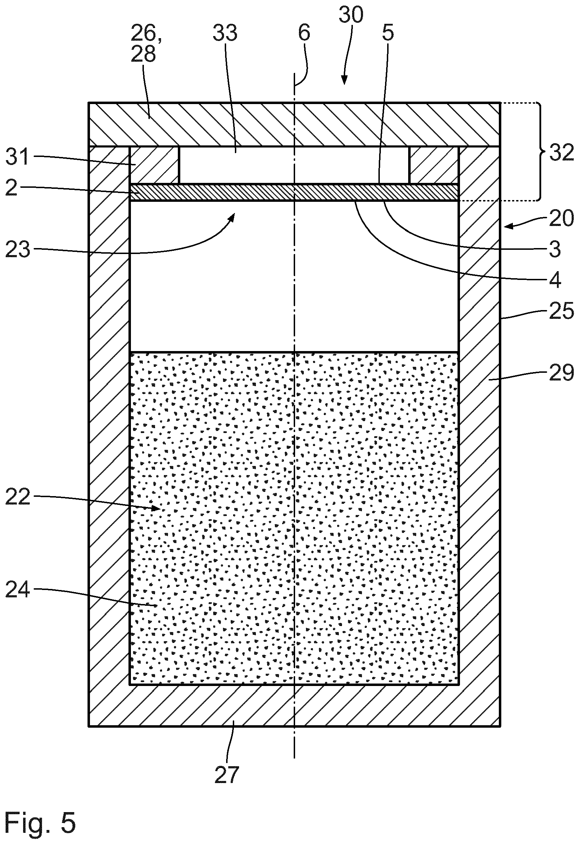

In Fig. 5 ist ein weiteres Ausführungsbeispiel einer Züchtungsvorrichtung 30 zur Züchtung eines (wiederum nicht mit dargestellten) SiC-Volumeneinkristalls gezeigt, wobei ein messtechnisch gemäß Fig. 1 untersuchter und dabei in die zweite Klasse eingestufter SiC-Keimkristall 2 verwendet wird. Als spannungsreduzierende Maßnahme ist bei der Züchtungsvorrichtung 30 im Unterschied zu der Züchtungsvorrichtung 19 gemäß Fig. 4 ein anderer Aufbau zur Anbringung des SiC-Keimkristalls 2 innerhalb des Züchtungstiegels 20 vorgesehen. Der SiC-Keimkristall 2 ist bei diesem Ausführungsbeispiel mittels eines Abstandsringes 31 an dem Tiegeldeckel 26 fest fixiert. Der Abstandsring 31 ist an der Scheiben-Rückseite 5 auf den SiC-Keimkristall 2 aufgeklebt. Eine weitere Klebeverbindung besteht zwischen dem Abstandsring 31 und dem Tiegeldeckel 26, so dass insgesamt eine festgefügte Keimeinheit 32 gebildet ist, die als Bestandteile den SiC-Keimkristall 2, den Abstandsring 31 und den Tiegeldeckel 26 aufweist. Der Abstandsring 31 ist konzentrisch zu der Kristallmittenlängsachse 6 angeordnet und umschließt einen zentralen Quer-Hohlraum 33, welcher sich axial an die Scheiben-Rückseite 5 des SiC-Keimkristalls 2 anschließt. Dieser Quer-Hohlraum 33 ist leer. Während der SiC-Züchtung kann sich in ihm Prozessgas ansammeln. Jedenfalls hat der Quer-Hohlraum 33 eine andere thermische Leitfähigkeit als der beispielsweise aus einem Graphit-Material bestehende Abstandsring 31, so dass eine ähnliche spannungsreduzierende Wirkung resultiert wie bei der Züchtungsvorrichtung 19 aufgrund der Spannungsreduktionselemente 17 und 18. Darüber hinaus hat auch der Quer-Hohlraum 33 an sich eine spannungsreduzierende Wirkung. Insgesamt werden die in dem in der Keimeinheit 32 montierten SiC-Keimkristall 2 vorhandenen anfänglichen Keim-Spannungen zumindest zu einem großen Teil während der SiC-Sublimationszüchtung des SiC-Volumeneinkristalls kompensiert und vorzugsweise nicht in den aufwachsenden SiC-Volumeneinkristall vererbt. Das Ergebnis ist wiederum ein sehr spannungsarmer SiC-Volumeneinkristall.

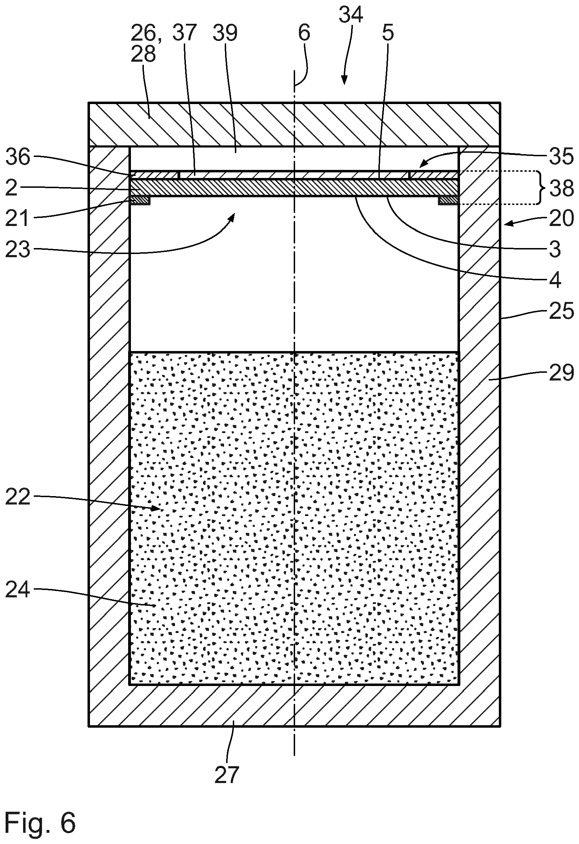

In Fig. 6 ist ein weiteres Ausführungsbeispiel einer Züchtungsvorrichtung 34 zur Züchtung eines (wiederum nicht mit dargestellten) SiC-Volumeneinkristalls gezeigt, bei der der mittels der Messanordnung 1 untersuchte SiC-Keimkristall 2 an der Scheiben-Rückseite 5 direkt mit einer Rückseiten-Schichtkomponente 35 beschichtet ist, um den im Kristallgefüge des SiC-Keimkristalls 2 festgestellten anfänglichen Keim-Spannungen als spannungsreduzierende Maßnahme entgegenzuwirken. Die Rückseiten-Schichtkomponente 35 ist zweilagig. Sie hat zwei radial nebeneinander angeordnete Lagen oder Einzelschichten 36 und 37, welche beide konzentrisch zu der Kristallmittenlängsachse 6 angeordnet sind. Beide Einzelschichten 36 und 37 bestehen aus voneinander verschiedenen Schichtmaterialien mit unterschiedlichen Wärmeleitfähigkeiten, so dass insgesamt ein ähnlicher spannungsreduzierender Einfluss resultiert, wie bei den Züchtungsvorrichtungen 19 und 30. Der SiC-Keimkristall 2 und die direkt an der Scheiben-Rückseite 5 an ihm anliegende Rückseiten-Schichtkomponente 35 bilden eine Keimeinheit 38, welche mit der Scheiben-Vorderseite 4 des SiC-Keimkristalls 2 im Bereich des Umfangsrands lose auf dem ringförmigen Keimhalter 21 aufliegt.

Auf der von dem SiC-Vorratsbereich 22 abgewandten Rückseite der Keimeinheit 38 ist ein Quer-Hohlraum 39 angeordnet. Er befindet sich zwischen dem Tiegeldeckel 26 und der Rückseiten-Schichtkomponente 35 der Keimeinheit 38. Dieser Quer-Hohlraum 39 stellt eine weitere spannungsreduzierende Maßnahme der Züchtungsvorrichtung 34 dar. Er ist insofern vorteilhaft, aber dennoch nur optional. Es gibt alternative Ausführungsbeispiele ohne einen solchen Quer-Hohlraum 39 zwischen der Keimeinheit 38 und dem Tiegeldeckel 26.

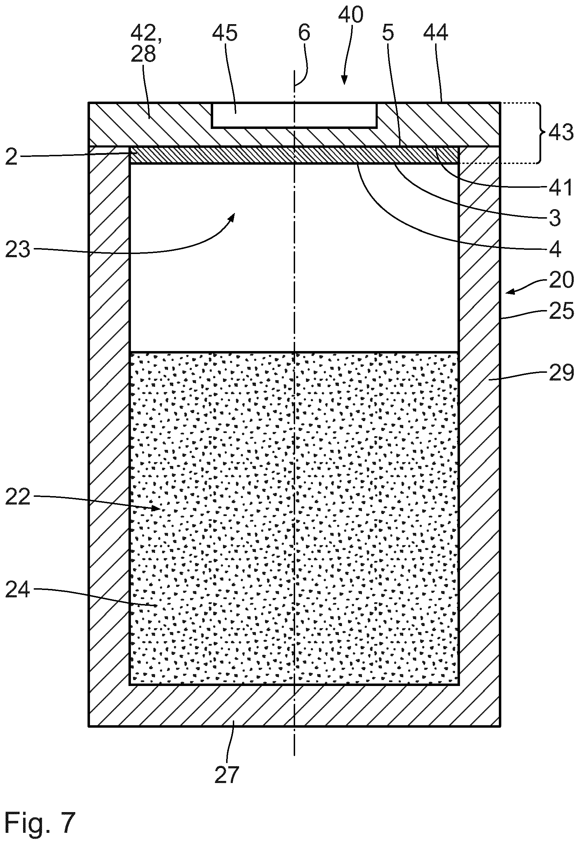

In Fig. 7 ist ein weiteres Ausführungsbeispiel einer Züchtungsvorrichtung 40 zur Sublimationszüchtung eines (wiederum nicht mit dargestellten) SiC-Volumeneinkristalls gezeigt, bei der der gemäß der messtechnischen Ermittlung der Spannungsverteilung in die zweite Klasse eingestufte SiC-Keimkristall 2 direkt an eine Deckelinnenseite 41 eines Tiegeldeckels 42 geklebt ist. Diese festgefügte Einheit aus dem SiC-Keimkristall 2 und dem Tiegeldeckel 42 bildet eine Keimeinheit 43, welche als spannungsreduzierende Maßnahme an einer Deckelaußenseite 44 des Tiegeldeckels 42 eine Ausnehmung 45 aufweist.

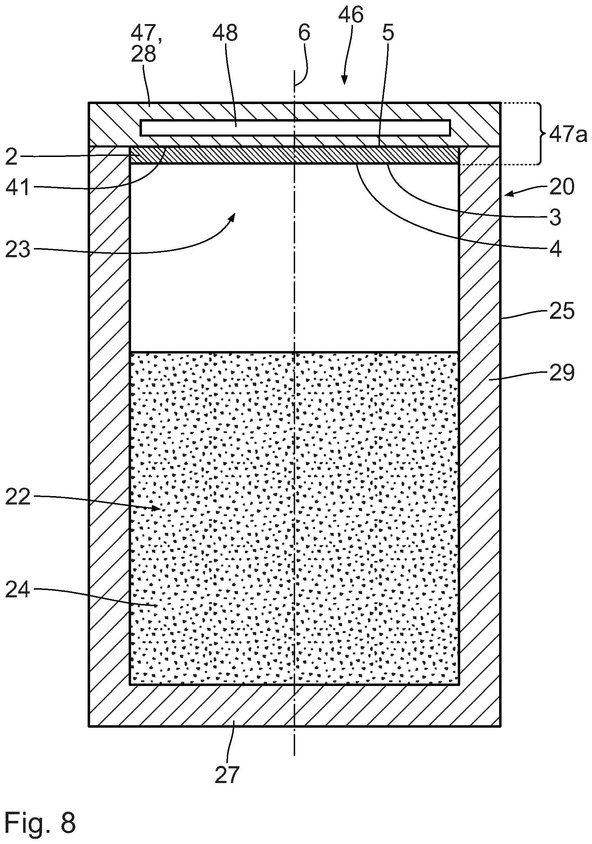

In Fig. 8 ist ein weiteres Ausführungsbeispiel einer Züchtungsvorrichtung 46 zur Sublimationszüchtung eines (wiederum nicht mit dargestellten) SiC-Volumeneinkristalls gezeigt, bei der der gemäß der messtechnischen Ermittlung der Spannungsverteilung in die zweite Klasse eingestufte SiC-Keimkristall 2 an die Deckelinnenseite 41 eines Tiegeldeckels 47 angeklebt ist. Die festgefügte Einheit aus dem SiC-Keimkristall 2 und

dem Tiegeldeckel 47 bildet eine Keimeinheit 47a. Die Züchtungsvorrichtung 46 unterscheidet sich von der Züchtungsvorrichtung 40 gemäß Fig. 7 im Wesentlichen durch die Ausgestaltung des Tiegeldeckels 47. Er hat in seinem Inneren einen in etwa zylindrischen und vollständig eingebetteten Quer-Hohlraum 48, welcher an die Stelle der Ausnehmung 45 bei der Züchtungsvorrichtung 40 tritt. Sowohl der innenliegende Quer-Hohlraum 48 der Züchtungsvorrichtung 46 als auch die Ausnehmung 45 der Züchtungsvorrichtung 40 sind spannungsreduzierende Maßnahmen und wirken insofern den im SiC-Keimkristall 2 festgestellten anfänglichen Keim-Spannungen entgegen.

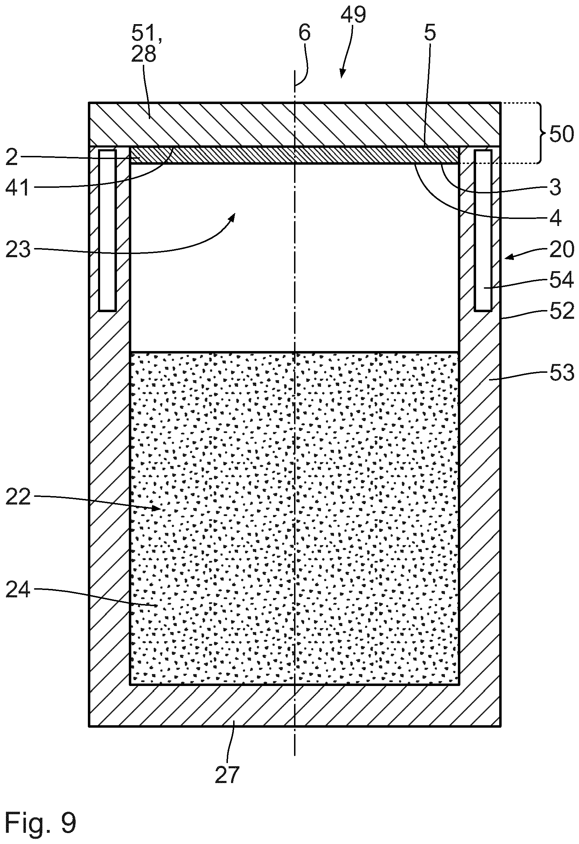

**[0067]** In Fig. 9 ist ein weiteres Ausführungsbeispiel einer Züchtungsvorrichtung 49 zur Sublimationszüchtung eines (wiederum nicht mit dargestellten) SiC-Volumeneinkristalls gezeigt, die eine Keimeinheit 50 aus einem Tiegeldeckel 51 und dem an der Deckelinnenseite 41 direkt angeklebten SiC-Keimkristall 2 aufweist. Der SiC-Keimkristall 2 ist gemäß der messtechnisch ermittelten Spannungsverteilung in die zweite Klasse eingestuft, so dass die Züchtungsvorrichtung 49 eine spannungsreduzierende Maßnahme zum Kompensieren der in dem SiC-Keimkristall 2 enthaltenen anfänglichen Keim-Spannungen hat. Hierbei handelt es sich um ein Tiegelgefäß 52, welches in seiner Seitenwand 53 einen innenliegenden vollständig eingebetteten Längs-Hohlraum 54 aufweist. Der Längs-Hohlraum 54 erstreckt sich in axialer Richtung und ist in axialer Richtung so innerhalb der Seitenwand 53 platziert, dass er den SiC-Keimkristall 2 und den Kristallwachstumsbereich 23 tangential umgibt.

**[0068]** Die mittels der Züchtungsvorrichtungen 19, 30, 34, 40, 46 und 49 hergestellten SiC-Volumeneinkristalle können nach Abschluss des Züchtungsvorgangs insbesondere einer weiteren spannungsmesstechnischen Untersuchung unterzogen werden. Dabei können die gleichen Messverfahren zum Einsatz kommen wie bei der Spannungsmessung an dem SiC-Keimkristall 2, also eine Messung der Raman-Verschiebung, eine Messung der Fotoelastizität, eine Röntgenbeugungsmessung und/oder eine Neutronenbeugungsmessung. Damit kann eine vollständige Verteilung der innerhalb des gezüchteten SiC-Volumeneinkristalls enthaltenen Volumeneinkristall-Spannungen erstellt werden. Auf dieser Grundlage wird dann über die weitere Verwendung entschieden. Besonders spannungsarme und auch anderweitig hochqualitative SiC-Volumeneinkristalle können vorzugsweise zur Herstellung neuer SiC-Keimkristalle herangezogen werden. Alternativ können die SiC-Volumeneinkristalle aber natürlich auch zur Herstellung von SiC-Substraten für die Bauelemente-Fertigung verwendet werden.

**[0069]** Insgesamt ermöglichen die vorstehend beschriebenen Sublimationszüchtungsverfahren bzw. Züchtungsvorrichtungen 19, 30, 34, 40, 46 und 49 unter Verwendung geeigneter spannungsreduzierender Maßnahmen die Herstellung sehr spannungsarmer SiC-Volumeneinkristalle.

**Patentansprüche**

1. Verfahren zur Herstellung eines SiC-Volumeneinkristalls mittels Sublimationszüchtung, wobei

   a) an einem scheibenförmigen einkristallinen SiC-Keimkristall (2) eine Spannungsmessung zur Erfassung anfänglicher innerer mechanischer Keim-Spannungen durchgeführt wird, wobei der SiC-Keimkristall (2) eine Scheiben-Vorderseite (4) mit einer zum Aufwachsen des zu züchtenden SiC-Volumeneinkristalls bestimmten Wachstumsoberfläche (3), eine Scheiben-Rückseite (5) und eine in einer axialen Richtung verlaufende Kristallmittenlängsachse (6) hat, wobei eine radiale Richtung senkrecht zur axialen Richtung orientiert ist,
   b) anhand der Spannungsmessung eine Klassifikation des SiC-Keimkristalls (2) vorgenommen wird, wobei der SiC-Keimkristall (2)

      b1) in eine erste Klasse eingestuft wird, wenn die erfassten anfänglichen Keim-Spannungen einen ersten Spannungsgrenzwert unterschreiten,
      b2) in eine zweite Klasse eingestuft wird, wenn die erfassten anfänglichen Keim-Spannungen zwischen dem ersten Spannungsgrenzwert und einem zweiten Spannungsgrenzwert liegen, oder
      b3) in eine dritte Klasse eingestuft wird, wenn die erfassten anfänglichen Keim-Spannungen den zweiten Spannungsgrenzwert überschreiten,

   und
   c) die eigentliche Sublimationszüchtung, während der der SiC-Volumeneinkristall auf dem SiC-Keimkristall (2) aufwächst, nur dann mit dem SiC-Keimkristall (2) durchgeführt wird, wenn er in die erste oder in die zweite Klasse eingestuft worden ist,
   c1) wobei bei Einstufung in die zweite Klasse mindestens eine spannungsreduzierende Maßnahme ergriffen wird.

2. Verfahren nach Anspruch 1, **dadurch gekennzeichnet, dass** anhand der Spannungsmessung eine Spannungsverteilung der anfänglichen Keim-Spannungen in dem SiC-Keimkristall (2) ermittelt wird.

3. Verfahren nach Anspruch 1 oder 2, **dadurch gekennzeichnet, dass** als erster Spannungsgrenzwert eine zwischen einem auf der Kristallmittenlängsachse (6) angeordneten Zentrum des SiC-Keimkristalls (2) und einem radialen Randbereich (12) des SiC-Keimkristalls (2) gemessene Spannungs-

differenz, die im Bereich zwischen 5 MPa und 15 MPa, insbesondere im Bereich zwischen 7,5 MPa und 12,5 MPa, und vorzugsweise bei 10 MPa liegt, verwendet wird.

4. Verfahren nach einem der vorhergehenden Ansprüche, **dadurch gekennzeichnet, dass** als zweiter Spannungsgrenzwert eine zwischen einem auf der Kristallmittenlängsachse (6) angeordneten Zentrum des SiC-Keimkristalls (2) und einem radialen Randbereich (12) des SiC-Keimkristalls (2) gemessene Spannungsdifferenz, die im Bereich zwischen 400 MPa und 600 MPa, insbesondere im Bereich zwischen 450 MPa und 550 MPa, und vorzugsweise bei 500 MPa liegt, verwendet wird.

5. Verfahren nach einem der vorhergehenden Ansprüche, **dadurch gekennzeichnet, dass** die Spannungsmessung an dem SiC-Keimkristall (2) mittels einer Röntgenbeugungsmessung, Neutronenbeugungsmessung, einer Messung der Raman-Verschiebung oder einer Messung der Photoelastizität durchgeführt wird.

6. Verfahren nach einem der vorhergehenden Ansprüche, **dadurch gekennzeichnet, dass** die mindestens eine spannungsreduzierende Maßnahme darin besteht, die Scheiben-Rückseite (5) des SiC-Keimkristalls (2) in Kontakt mit Spannungsreduktionselementen (17, 18) zu bringen, wobei die Spannungsreduktionselemente (17, 18) unterschiedliche Wärmeleitfähigkeiten haben.

7. Verfahren nach einem der vorhergehenden Ansprüche, **dadurch gekennzeichnet, dass** die mindestens eine spannungsreduzierende Maßnahme darin besteht, dass zur Sublimationszüchtung eine Vorrichtung (30; 34; 46) verwendet wird, die in einem Bereich, der sich axial an die Scheiben-Rückseite (5) des in die Vorrichtung (30; 34; 46) eingebrachten SiC-Keimkristalls (2) anschließt, mindestens einen Quer-Hohlraum (33; 39; 48) aufweist.

8. Verfahren nach Anspruch 7, **dadurch gekennzeichnet, dass** der Quer-Hohlraum (33) unmittelbar benachbart zur der Scheiben-Rückseite (5) des SiC-Keimkristalls (2) angeordnet wird.

9. Verfahren nach Anspruch 7 oder 8, **dadurch gekennzeichnet, dass** der Quer-Hohlraum (48) in einer axialen Stirnwand (28, 47) eines zur Sublimationszüchtung als Bestandteil der Vorrichtung (46) verwendeten Züchtungstiegels (20) angeordnet wird.

10. Verfahren nach einem der vorhergehenden Ansprüche, **dadurch gekennzeichnet, dass** die mindestens eine spannungsreduzierende Maßnahme darin besteht, dass zur Sublimationszüchtung eine Vorrichtung (40) mit einem Züchtungstiegel (20) verwendet wird, wobei eine benachbart zu dem in die Vorrichtung (40) eingebrachten SiC-Keimkristall (2) angeordnete axiale Stirnwand (28, 42) des Züchtungstiegels mindestens eine Ausnehmung (45) aufweist.

11. Verfahren nach einem der vorhergehenden Ansprüche, **dadurch gekennzeichnet, dass** die mindestens eine spannungsreduzierende Maßnahme darin besteht, dass zur Sublimationszüchtung eine Vorrichtung (49) mit einem Züchtungstiegel (20) verwendet wird, wobei eine den SiC-Keimkristall (2) und einen Kristallwachstumsbereich (23) umgebende Seitenwand (53) des Züchtungstiegels (20) mindestens einen Längs-Hohlraum (54) aufweist.

12. Verfahren nach einem der vorhergehenden Ansprüche, **dadurch gekennzeichnet, dass** die mindestens eine spannungsreduzierende Maßnahme darin besteht, dass die Scheiben-Rückseite (5) des SiC-Keimkristalls (2) mit einer Rückseiten-Schichtkomponente (35) beschichtet wird.

13. Verfahren nach Anspruch 12, **dadurch gekennzeichnet, dass** für die Rückseiten-Schichtkomponente (35) mindestens zwei voneinander verschiedene Schichtmaterialien mit insbesondere unterschiedlichen Wärmeleitfähigkeiten vorgesehen werden.

14. Verfahren nach einem der vorhergehenden Ansprüche, **dadurch gekennzeichnet, dass** eine Spannungsverteilung der inneren mechanischen Volumeneinkristall-Spannungen in dem hergestellten SiC-Volumeneinkristall ermittelt wird, und anhand der so ermittelten Spannungsverteilung die weitere Verwendung des SiC-Volumeneinkristalls festgelegt wird.

15. Verfahren nach Anspruch 14, **dadurch gekennzeichnet, dass** die Spannungsverteilung der Volumeneinkristall-Spannungen mittels einer Röntgenbeugungsmessung, Neutronenbeugungsmessung, einer Messung der Raman-Verschiebung oder einer Messung der Photoelastizität ermittelt wird.

Fig. 1

Fig. 2

Fig. 3

Fig. 4

Fig. 5

Fig. 6

Fig. 7

Fig. 8

Fig. 9

Europäisches Patentamt
European Patent Office
Office européen des brevets

# EUROPÄISCHER RECHERCHENBERICHT

**Nummer der Anmeldung**

EP 24 16 2681

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (IPC) |
|---|---|---|---|
| X | JP 2013 245144 A (BRIDGESTONE CORP) 9. Dezember 2013 (2013-12-09) | 1,14 | INV. C30B23/02 |
| Y | * Abbildung 1 * * Absätze [0020] - [0060] * | 2-13,15 | C30B29/36 |
| | - - - - - | | |
| Y | EP 3 048 641 A1 (NIPPON STEEL & SUMIKIN MAT CO [JP]) 27. Juli 2016 (2016-07-27) * Beispiel 1 * * Tabelle 1 * | 2-5,15 | |
| | - - - - - | | |
| Y | EP 2 954 101 B1 (DDP SPECIALTY ELECTRONIC MAT US 9 LLC [US]) 19. Februar 2020 (2020-02-19) * Abbildungen 2-4 * * Absätze [0029], [0035] - [0045] * | 6-11 | |
| | - - - - - | | |
| Y | US 2011/300323 A1 (STRAUBINGER THOMAS [DE] ET AL) 8. Dezember 2011 (2011-12-08) * Abbildung 4 * * Absätze [0055], [0059] * | 12,13 | |
| | - - - - - | | |

**RECHERCHIERTE SACHGEBIETE (IPC)**

C30B

Der vorliegende Recherchenbericht wurde für alle Patentansprüche erstellt

| Recherchenort | Abschlußdatum der Recherche | Prüfer |
|---|---|---|
| Den Haag | 31. Juli 2024 | Schmitt, Christian |

EPO FORM 1503 03.82 (P04C03)

## ANHANG ZUM EUROPÄISCHEN RECHERCHENBERICHT
## ÜBER DIE EUROPÄISCHE PATENTANMELDUNG NR.

EP 24 16 2681

In diesem Anhang sind die Mitglieder der Patentfamilien der im obengenannten europäischen Recherchenbericht angeführten Patentdokumente angegeben.
Die Angaben über die Familienmitglieder entsprechen dem Stand der Datei des Europäischen Patentamts am
Diese Angaben dienen nur zur Unterrichtung und erfolgen ohne Gewähr.

31-07-2024

| Im Recherchenbericht angeführtes Patentdokument | Datum der Veröffentlichung | Mitglied(er) der Patentfamilie | Datum der Veröffentlichung |
|---|---|---|---|
| JP 2013245144 A | 09-12-2013 | KEINE | |
| EP 3048641 A1 | 27-07-2016 | CN 105556649 A | 04-05-2016 |
| | | EP 3048641 A1 | 27-07-2016 |
| | | JP 5944873 B2 | 05-07-2016 |
| | | JP 2015059073 A | 30-03-2015 |
| | | KR 20160058867 A | 25-05-2016 |
| | | KR 20170031268 A | 20-03-2017 |
| | | US 2016231256 A1 | 11-08-2016 |
| | | WO 2015040895 A1 | 26-03-2015 |
| EP 2954101 B1 | 19-02-2020 | CN 105051268 A | 11-11-2015 |
| | | CN 111676513 A | 18-09-2020 |
| | | EP 2954101 A1 | 16-12-2015 |
| | | JP 6663548 B2 | 13-03-2020 |
| | | JP 2016506902 A | 07-03-2016 |
| | | KR 20150115902 A | 14-10-2015 |
| | | US 2014220296 A1 | 07-08-2014 |
| | | US 2017137963 A1 | 18-05-2017 |
| | | WO 2014123635 A1 | 14-08-2014 |
| US 2011300323 A1 | 08-12-2011 | DE 102010029756 A1 | 08-12-2011 |
| | | US 2011300323 A1 | 08-12-2011 |

EPO FORM P0461

Für nähere Einzelheiten zu diesem Anhang : siehe Amtsblatt des Europäischen Patentamts, Nr.12/82

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- US 8865324 B2
- EP 3048641 A1
- CN 218860954 U
- CN 116334748 A
- US 20110229719 A1
- CN 110306239 A